# EUROPÄISCHE PATENTANMELDUNG

(11) **EP 0 775 923 A2**
(43) Veröffentlichungstag der Anmeldung: **28.05.1997**
(21) Anmeldenummer: 96203236.3
(22) Anmeldetag: 19.11.1996
(51) Int. Cl.: G01V 3/14

(54) **MR-Verfahren und Anordnung zur Durchführung des Verfahrens**

(30) Priorität: 24.11.1995 DE 19543785
(71) Anmelder: Philips Patentverwaltung GmbH, 22335 Hamburg (DE); PHILIPS ELECTRONICS N.V., 5621 BA Eindhoven (NL)
(72) Erfinder: Rasche, Volker, Dr., Röntgenstrasse 24, 22335 Hamburg (DE); Börnert, Peter, Dr., Röntgenstrasse 24, 22335 Hamburg (DE); Lüdeke, Kai-Michael, Röntgenstrasse 24, 22335 Hamburg (DE); Kuhn, Michael, Dr., Röntgenstrasse 24, 22335 Hamburg (DE)
(74) Vertreter: Hartmann, Heinrich, Dipl.-Ing.

(57) **Zusammenfassung**

Die Erfindung betrifft ein MR-Verfahren, mit dem die Position eines Gegenstandes, beispielsweise eines Katheters in einem zu untersuchenden Körper bestimmt wird, um den Gegenstand während seiner Bewegung im Körper zu verfolgen. Gleichzeitig sollen Informationen über die Anatomie in der Umgebung des Gegenstandes gewonnen werden. Dabei soll eine möglichst hohe zeitliche und räumliche Auflösung erreicht werden. Dazu sieht die Erfindung vor, daß mittels einer an dem eingeführten Gegenstand angebrachten Mikrospule die Kernmagnetisierung im Umgebungsbereich des Gegenstandes bestimmt wird, woraus sich die Position des Gegenstandes bestimmen läßt. Danach wird mittels einer Hochfrequenzspulenanordnung ein Line-Scan um diese Position durchgeführt zur Bestimmung der Kernmagnetisierung in einem linienförmigen Bereich.

## Beschreibung

Die Erfindung betrifft ein MR-Verfahren, bei dem die Position eines in einen zu untersuchenden Körper eingeführten Gegenstandes bestimmt wird zur Verfolgung des Gegenstandes während seiner Bewegung im Körper.

Ein derartiges Verfahren ist aus Magnetic Resonance in Medicine, 29, p. 411 - 415 (1993) bekannt. Mittels einer an einem chirurgischen Instrument angebrachten Mikrospule werden MR-Signale von solchen Kernspins detektiert, die sich in der Umgebung der Mikrospule befinden. Während der Bewegung des Instruments werden MR-Bilder auf der Basis von Gradientenechos erzeugt, wobei die Gradientenrichtung nach jedem Hochfrequenzimpuls in eine andere Richtung umgeschaltet wird. Die Frequenz der während der Einwirkung der magnetischen Gradientenfelder empfangenen Kernresonanzsignale ist linear mit der Position der Mikrospule verknüpft, so daß durch eine eindimensionale Fouriertransformation dieser Signale die Spitze des Instruments lokalisiert werden kann.

Bei interventionellen Applikationen stellt sich häufig die Aufgabe, die Position eines chirurgischen Instrumentes, beispielsweise eines Katheters während des Eingriffes verfolgen zu können und gleichzeitig zusätzliche anatomische Information über die Umgebung des Instrumentes zu gewinnen. Ein erstes Problem liegt dabei in der Notwendigkeit einer sehr hohen zeitlichen Auflösung der Position des Instrumentes.

Das zweite Problem besteht darin, die räumliche Position des Instrumentes möglichst exakt auflösen zu können. Bei einem aus der DE-A 43 10 993 bekannten Verfahren wird zunächst ein MR-Übersichtsbild erstellt. Während der Intervention wird nur noch die Position des Instrumentes, das einen guten MR-Kontrast aufweist, bestimmt. Die so gewonnenen Positionsdaten werden dem präinterventionell akquirierten Datensatz des MR-Übersichtsbildes überlagert, so daß der Chirurg zu jeder Zeit über die Position des Instrumentes und der vorhandenen Anatomie in dessen Umgebung informiert ist. Allerdings kann sich im Verlauf der Intervention die Anatomie beispielsweise durch Bewegung des Körpers oder durch den chirurgischen Eingriff ändern, so daß bei der Einblendung der Position in das MR-Übersichtsbild Fehler auftreten können und im schlimmsten Fall dem Chirurgen eine nicht mit der Position des Instrumentes korrelierende Anatomie gezeigt wird.

Der vorliegenden Erfindung liegt die Aufgabe zugrunde, ein MR-Verfahren der eingangs genannten Art weiterzubilden.

Diese Aufgabe wird erfindungsgemäß dadurch gelöst, daß mindestens eine Koordinate der Position des Gegenstandes bestimmt wird, daß danach die Kernmagnetisierung in einem linienförmigen Bereich um diese Position bestimmt wird zur Erstellung von MR-Bildern eines Umgebungsbereiches des Gegenstandes und daß dieses Verfahren fortlaufend während der Bewegung des Gegenstandes für verschiedene Positionen des Gegenstandes wiederholt wird. Bei der Erfindung ist durch die Position des Gegenstandes festgelegt, wo der linienförmige Bereich, in dem die Kernmagnetisierung bestimmt werden soll, liegt, d.h. wo ein sogenannter Line-Scan akquiriert werden soll. Aufgrund der fortlaufenden Durchführung von Line-Scans während der Intervention lassen sich MR-Bilder erstellen, die den Umgebungsbereich des von dem Instrument zurückgelegten Weges und der aktuellen Position des Instrumentes zeigen. Vorteilhaft ist dabei, daß keine Abweichung zwischen der tatsächlichen Position des Gegenstandes und der im MR-Bild angezeigten Position des Gegenstandes auftreten kann, da Positionsbestimmung und Erstellung eines oder mehrerer Line-Scans um diese Position zeitlich unmittelbar nacheinander erfolgen.

In einer Ausgestaltung ist erfindungsgemäß vorgesehen, daß alle drei Koordinaten der Position des Gegenstandes bestimmt werden und daß danach die Kernmagnetisierung in einem, zwei oder drei zueinander orthogonalen linienförmigen Bereichen um diese Position bestimmt wird. Die Erstellung von zueinander orthogonalen Line-Scans hat für den Arzt den Vorteil, daß er sich anhand der damit erstellten MR-Bilder sehr leicht orientieren kann und sehr leicht erkennt, wo sich der eingeführte Gegenstand gerade befindet. Außerdem ist die Position des Gegenstandes exakt bestimmt, da alle drei Positionskoordinaten bestimmt sind.

Eine alternative Ausgestaltung sieht erfindungsgemäß vor, daß nacheinander in drei Verfahrensschritten die drei Koordinaten der Position des Gegenstandes sowie die Kernmagnetisierung in drei orthogonal zueinander angeordneten linienförmigen Bereichen um diese Position bestimmt werden, wobei in einem Verfahrensschritt genau eine Koordinate der Position des Gegenstandes und die Kernmagnetisierung in einem linienförmigen Bereich um diese Position bestimmt werden. Dies bedeutet, daß in einem ersten Schritt nur eine Koordinate bestimmt und ein Line-Scan durchgeführt werden und in einem zweiten und dritten Schritt jeweils eine weitere Koordinate und ein weiterer Line-Scan, der jeweils orthogonal zum ersten Line-Scan liegt. Die Ungenauigkeit aufgrund des von dem Gegenstand zurückgelegten Weges während dieser drei Verfahrensschritte ist zu vernachlässigen, da die drei Verfahrensschritte zusammen in etwa 0,1 sec durchgeführt werden können und der zurückgelegte Weg des Gegenstandes in dieser Zeit im allgemeinen nur sehr kurz sein wird. Alternativ kann auch beim zweiten und dritten Verfahrensschritt die Durchführung eines Line-Scans entfallen. Außerdem kann zur Erzeugung einer isotropen Darstellung das Verfahren derart erweitert werden, daß der Gegenstand nach der Durchführung eines Line-Scans in einer bestimmten Richtung eine bestimmte Strecke zurückgelegt haben muß, bevor der nächste Line-Scan in der gleichen Richtung durchgeführt wird.

Besonders vorteilhaft ist erfindungsgemäß vorgesehen, daß die Bestimmung mindestens einer Koordinate der Position des Gegenstandes und die Bestimmung der Kernmagnetisierung in einem linienförmigen Bereich mittels einer einzigen MR-Sequenz erfolgen. Eine derartige MR-Sequenz umfaßt beispielsweise einen Hochfrequenz-Anregungsimpuls, einen Hochfrequenz-Refokussierungsimpuls sowie drei zeitlich nacheinander angeschaltete Magnetfeldgradienten unterschiedlicher Richtungen. Diese Kombination aus Positionsbestimmung und Line-Scan in einer MR-Sequenz ist besonders schnell. Um weitere Koordinaten der Position und weitere Linie-Scans um dieselbe Position zu erhalten, wird die MR-Sequenz ein oder zwei weitere Male mit anderen Magnetfeldgradienten wiederholt.

Erfindungsgemäß sieht eine Ausgestaltung vor, daß mindestens ein MR-Übersichtsbild erstellt wird und daß die Position des Gegenstandes und/oder der linienförmige Bereich um diese Position in das MR-Übersichtsbild eingeblendet werden. Der linienförmige Bereich kann einerseits dazu dienen, die Position des Gegenstandes an der richtigen Stelle in das MR-Übersichtsbild einzublenden. Andererseits kann auch das wahrend des Intervention durch die Line-Scans erstellte MR-Bild in das MR-Übersichtsbild eingeblendet werden, da sich während der Intervention beispielsweise durch chirurgische Eingriffe die Anatomie im Vergleich zu der auf dem MR-Übersichtsbild dargestellten Anatomie verändert haben könnte. Dadurch wird letztlich eine genauere und aktuellere Darstellung erreicht, ohne daß der Gesamtüberblick verloren geht.

Eine weitere Ausgestaltung der Erfindung sieht vor, daß die aktuelle Position des Gegenstandes oder der von dem Gegenstand zurückgelegte Weg verwendet wird zur Auswahl der anzuregenden Schicht für die nächstfolgende Positionsbestimmung. Dadurch wird gewährleistet, daß der Gegenstand während der Positionsbestimmung und der Durchführung des Line-Scans in der angeregten Schicht liegt. Ist die Geschwindigkeit des Gegenstandes derart groß, daß der Gegenstand zwischen zwei Positionsbestimmungen sich aus der angeregten Schicht heraus bewegt, können auch extra Positionsbestimmungen durchgeführt werden zur Bestimmung der Geschwindigkeit und der Bewegungsrichtung des Katheters, um für die nächste Positionsbestimmung und/oder den nächsten Line-Scan die richtige Schicht anzuregen. Aus den bisher bestimmten Positionen des Gegenstandes kann auch der von dem Gegenstand zurückgelegte Weg näherungsweise bestimmt werden und daraus abgeschätzt werden, wohin sich der Gegenstand bewegen wird. Diese Schätzung kann ebenfalls zur Bestimmung der anzuregenden Schichten herangezogen werden.

Eine Anordnung zur Durchführung des erfindungsgemäßen Verfahrens ist versehen mit
- einer Gradientenspulenanordnung zur Erzeugung von magnetischen Gradientenfeldern in einem von einem stationären homogenen Magnetfeld durchsetzten Untersuchungsbereich,
- einer Hochfrequenzspulenanordnung zur Erzeugung eines hochfrequenten Magnetfeldes bzw. zum Empfang von MR-Signalen aus dem Untersuchungsbereich,
- einem in den Untersuchungskörper einzuführenden Gegenstand mit Mitteln zum Empfang von MR-Signalen aus dem Umgebungsbereich,
- Mitteln zur Steuerung des zeitlichen Verlaufs der Ströme in der Gradientenspulenanordnung und/oder der Hochfrequenzspulenanordnung und/oder der Mittel, wobei die Steuerung derart erfolgt, daß mindestens eine Koordinate der Position des Gegenstandes bestimmt wird, daß danach die Kernmagnetisierung in einem linienförmigen Bereich um diese Position bestimmt wird zur Erstellung von MR-Bildern eines Umgebungsbereiches des Gegenstandes und daß dieses Verfahren fortlaufend während der Bewegung des Gegenstandes für verschiedene Positionen des Gegenstandes wiederholt wird, und mit
- Mitteln zur Wiedergabe der aus den gemessenen Werten erstellten MR-Bilder.

Eine Weiterbildung dieser Anordnung sieht erfindungsgemäß vor, daß die Mittel zum Empfang von MR-Signalen aus dem Umgebungsbereich eine Mikrospule oder einen Permanent- oder Elektromagneten aufweisen. Es sind auch noch weitere geeignete Mittel zum Empfang von MR-Signalen denkbar, die spezielle Eigenschaften von bestimmten Metallen oder bestimmten Flüssigkeiten ausnutzen.

Mit dem erfindungsgemäßen Verfahren können anatomische Informationen aus bis zu drei orthogonalen Flächen entlang der Trajektorie eines chirurgischen Instrumentes während einer Intervention gewonnen werden. Aufgrund der hohen räumlichen und zeitlichen Auflösung können diese Informationen dem Arzt direkt als Orientierungshilfe dienen. Alternativ können die so gewonnenen Daten auch zur verbesserten Korrelation der Position des Instrumentes mit präinterventionell akquirierten Daten, wie beispielsweise einem MR-Übersichtsbild, verwendet werden.

Die Erfindung wird nachstehend anhand der Zeichnungen näher erläutert. Es zeigen:
- Fig. 1: ein Kernspinuntersuchungsgerät zur Durchführung des erfindungsgemäßen Verfahrens,
- Fig. 2: ein Blockschaltbild eines solchen Gerätes,
- Fig. 3: den zeitlichen Verlauf verschiedener Signale bei einer für die Durchführung des erfindungsgemäßen Verfahrens vorgesehenen Sequenzfolge,
- Fig. 4: eine weitere Sequenzfolge zur Bestimmung dreier Positionskoordinaten,
- Fig. 5: eine alternative Sequenzfolge und
- Fig. 6: den Verlauf eines Katheters und während dessen Bewegung dargestellte linienförmige Bereiche.

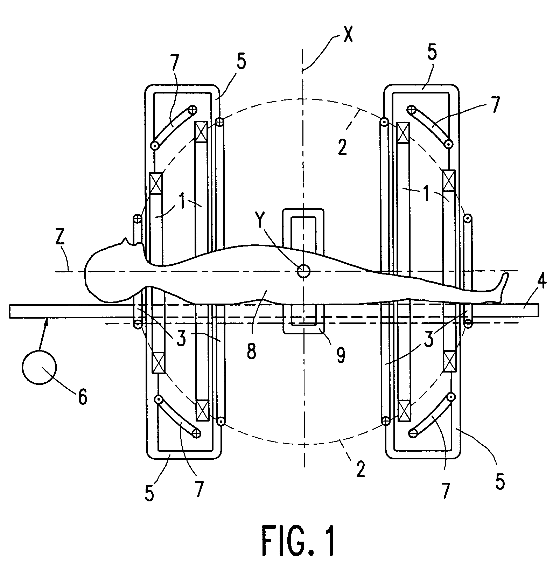

Das in Fig. 1 schematisch dargestellte Kernspinuntersuchungsgerät enthält eine aus vier Spulen 1 bestehende Anordnung zur Erzeugung eines homogenen stationären Magnetfeldes. Die zur z-Achse konzentrisch angeordneten Spulen 1 können auf einer Kugelfläche 2 angeordnet sein. Im Innern dieser Spulen 1 befindet sich der zu untersuchende Patient 8 auf einer Tischplatte 4, die mittels eines Motorantriebes 6 in Längsrichtung des Patienten 8, d.h. in z-Richtung verschiebbar ist.

Zur Erzeugung eines in z-Richtung verlaufenden und sich in dieser Richtung linear ändernden Magnetfeldes sind vier Spulen 3 auf der Kugeloberfläche 2 oder einer Zylinderoberfläche angeordnet. Weiterhin sind vier Spulen 7 vorgesehen, die ebenfalls ein in z-Richtung verlaufendes magnetisches Gradientenfeld erzeugen, dessen Gradient jedoch in x-Richtung (vertikal) verläuft. Ein in z-Richtung verlaufendes magnetisches Gradientenfeld mit einem Gradienten in y-Richtung (senkrecht zur Zeichenebene der Fig. 1) wird von vier Spulen 5 erzeugt, die mit den Spulen 7 identisch sein können, die jedoch diesen gegenüber um 90° räumlich versetzt angeordnet sind. Von diesen vier Spulen 5 sind in Fig. 1 nur zwei dargestellt.

Weiterhin ist eine Hochfrequenzspule 9 vorgesehen, die ein im wesentlichen homogenes und senkrecht zur Richtung des stationären homogenen Magnetfeldes (d.h. senkrecht zur z-Richtung) verlaufendes hochfrequentes Magnetfeld erzeugt. Der Hochfrequenzspule 9 wird während jedes Hochfrequenzimpulses ein hochfrequenter modulierter Strom von einem Hochfrequenzgenerator zugeführt. Die Hochfrequenzspule 9 könnte ebenfalls zum Empfangen der im Untersuchungsbereich erzeugten Kernresonanzsignale dienen. Zweckmäßigerweise wird dafür jedoch eine gesonderte, in Fig. 1 nicht näher dargestellte Hochfrequenzempfangsspule verwendet.

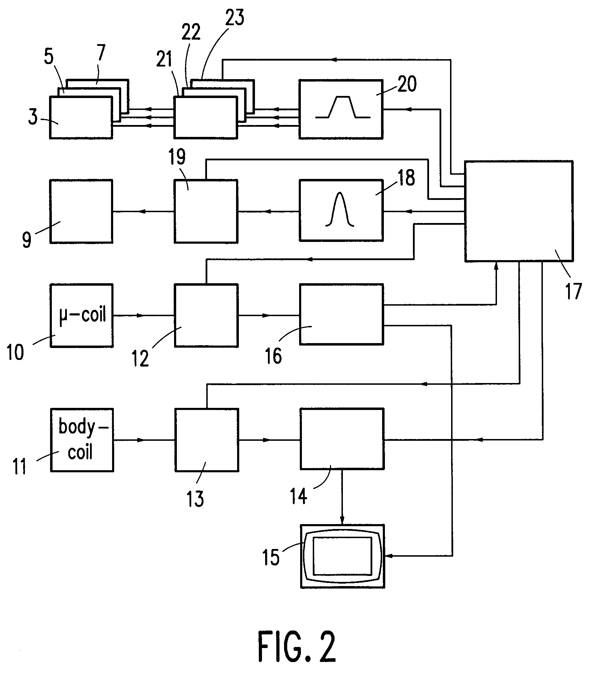

In Fig. 2 ist ein Blockschaltbild eines Kernspinuntersuchungsgeräts zur Durchführung des erfindungsgemäßen Verfahrens dargestellt. Den Strom für die Gradientenspulen 3, 5 und 7 wird von Gradientenverstärkern 21, 22, 23 geliefert, die von einer Steuereinheit 17 gesteuert werden. Der zeitliche Verlauf der magnetischen Gradientenfelder wird von einem Gradienten-Wellenform-Generator 20 bestimmt, der ebenfalls von der Steuereinheit 17 gesteuert wird. Weiterhin steuert die Steuereinheit 17 die Verstärkerung eines Verstärkers 19 sowie einen Generator 18 für die Hochfrequenzspule 9.

An einem Katheter, der in den Körper des Patienten eingeführt wird und dessen Weg durch den Körper verfolgt werden soll, ist eine kleine Mikrospule 10 (µ-coil) angebracht, die nur aus einem kleinen Umgebungsbereich um die Mikrospule 10 MR-Signale empfangen kann. Die empfangenen Signale werden in einem Empfänger 12 verstärkt, mit einem Signal mit einer konstanten Frequenz gemischt und digitalisiert. Das Ausgangssignal wird einer Recheneinheit 16 zugeführt, die daraus die Position der Mikrospule 10 und damit auch des Katheters bestimmt.

Weiterhin ist die schon erwähnte Hochfrequenzempfangsspule 11 (body-coil) als Block dargestellt, die in der Regel als Ganzkörperspule ausgestaltet ist, aber auch aus mehreren Synergiespulen bestehen kann. Die davon gemessenen MR-Signale werden ebenfalls von einem Empfänger 13 verstärkt, gemischt und digitalisiert. Anschließend wird das digitalisierte Signal einer Bildrekonstruktionseinheit 14 zugeführt, in der ein MR-Bild rekonstruiert wird, das auf einem Monitor 15 wiedergegeben wird. Die Position des Katheters kann ebenfalls in das MR-Bild eingeblendet werden.

Der Zeitpunkt und die Dauer, während der die Empfangsspulen 10 und 11 MR-Signale empfangen sollen, wird von der Steuereinheit 17 über die Empfänger 12 und 13 gesteuert. Die Art der Anregung durch Hochfrequenzimpulse sowie die Art und die zeitliche Abfolge der Gradientenfelder ist abhängig von der Position des Katheters, weshalb über eine Verbindung von der Recheneinheit 16 zur Steuereinheit 17 die Information über die Position geleitet wird.

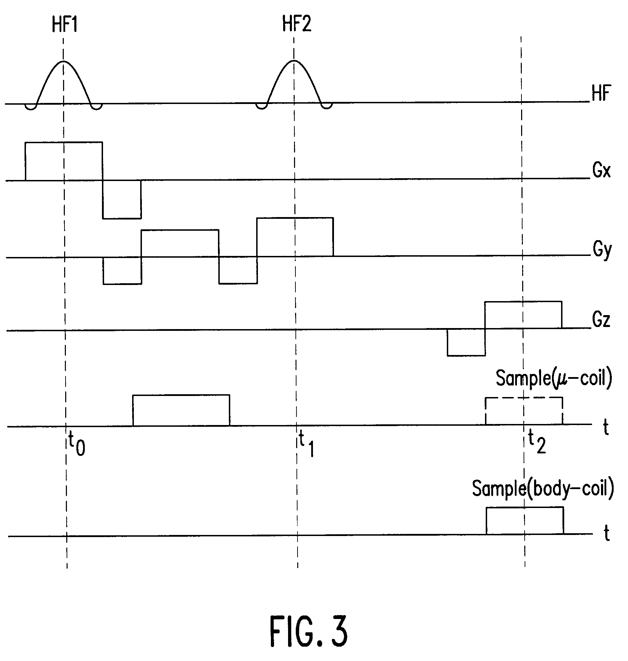

In Fig. 3 ist eine Sequenzfolge für das erfindungsgemäße Verfahren dargestellt, mit der zwei Koordinaten der Position des Katheters und gleichzeitig die Kernmagnetisierung in einem linienförmigen Bereich (im folgenden kurz Line-Scan genannt) um diese Position bestimmt werden kann. Die erste Zeile von Fig. 3 zeigt die zeitliche Lage der Hochfrequenzimpulse, die zweite bis vierte Zeile zeigen die während oder nach den Hochfrequenzimpulsen wirksamen magnetischen Gradientenfelder Gₓ, G_{y}, G_{z}, deren Gradienten in x-, y- bzw. z-Richtung verlaufen. In der fünften Zeile ist die zeitliche Lage des Zeitraums gezeigt, innerhalb dessen die von der Mikrospule 10 empfangenen Signale vom Empfänger 12 verarbeitet werden. In der sechsten Zeile ist die zeitliche Lage des Zeitraums dargestellt, innerhalb dessen die von der Hochfrequenzempfangsspule 11 empfangenen Signale vom Empfänger 13 verarbeitet werden.

Die Sequenz beginnt mit einem 90°-Hochfrequenzimpuls HF1 zum Zeitpunkt t₀, der von einem magnetischen Gradientenfeld Gₓ begleitet wird, dessen Gradient in x-Richtung verläuft. Die Mittenfrequenz des Hochfrequenzimpulses HF1, die Größe dieses sog. Selektionsgradienten des magnetischen Gradientenfeldes Gₓ und dessen zeitlicher Verlauf sind so gewählt, daß eine Anregung und anschließende Rephasierung der Kernmagnetisierung in einer Schicht erfolgt, die senkrecht zur x-Richtung verläuft. Zu dem Zeitpunkt, in dem das Gradientenfeld Gₓ seine Richtung ändert, wird ein zweites Gradientenfeld G_{y} angeschaltet, dessen Gradient in y-Richtung verläuft. Das Gradientenfeld G_{y} weist zunächst solange negative Polarität auf, bis das Gradientenfeld Gₓ abgeschaltet wird. Zu diesem Zeitpunkt wechselt das Gradientenfeld G_{y} die Polarität. Während der Zeit, in der das magnetische Gradientenfeld G_{y} nun konstant ist, werden die im Untersuchungsbereich erzeugten MR-Signale von der Mikrospule erfaßt, was in der fünften Zeile erkennbar ist. Da die Mikrospule nur MR-Signale aus einem sehr kleinen Bereich empfangen kann, läßt sich nach Fouriertransformation des gemessenen Signals auf die Position der Mikrospule und damit des Katheters entlang der y-Achse schließen, da das Signal nur an einer Stelle einen Peak aufweist. Nach dem Zeitraum mit positiver Polarität des Gradientenfeldes G_{y} und nach dem Ende der Meßwerterfassung durch die Mikrospule wird die Polarität des Gradientenfeldes G_{y} wieder in negative Richtung umgekehrt. Das Gradientenfeld G_{y} bleibt nur so lange mit negativer Polarität angeschaltet, bis das zeitliche Integral über den Gradienten G_{y} vom Anschalten bis zum Ende des zweiten Zeitraumes mit negativer Polarität gleich Null ist, damit zu diesem Zeitpunkt alle Kernspins wieder in Phase sind.

Im Anschluß daran erfolgt wiederum eine Polaritätsumkehr des Gradientenfeldes G_{y} in positive Richtung, ein sog. Selektionsgradient in y-Richtung, wobei gleichzeitig ein 180°-Hochfrequenzimpuls HF2 mit dem Maximum zum Zeitpunkt t₁ erzeugt wird. Dadurch wird eine senkrecht zur y-Richtung orientierte Schicht refokussiert. Nach Abschaltung des Gradienten G_{y} und des Hochfrequenzimpulses HF2 wirkt schließlich ein Gradientenfeld G_{z} auf den Untersuchungsbereich ein. Die Richtung dieses Gradienten wird nach einem bestimmten Zeitpunkt umgekehrt, wobei der zeitliche Verlauf so gewählt ist, daß das zeitliche Integral über den Gradienten bis zur Polaritätsumkehr halb so groß ist wie das zeitliche Integral von der Polaritätsumkehr bis zum Abschalten des Gradientenfeldes G_{z}.

Während des Zeitraums, in dem das Gradientenfeld G_{z} nach der Polaritätsumkehr konstant ist, werden die im Untersuchungsbereich erzeugten MR-Signale von der Hochfrequenzempfangsspule erfaßt, d.h. der zugehörige Empfänger 13 (in Fig. 2) wird auf Empfang geschaltet, was in der sechsten Zeile angedeutet ist. Dadurch wird die Kernmagnetisierung (ein sog. Spin-Echo) in einem sich in z-Richtung erstreckenden linienförmigen Bereich erfaßt, wobei sich dieser linienförmige Bereich um die Position des Katheters erstreckt.

Zur gleichen Zeit kann auch die Position des Katheters in z-Richtung bestimmt werden, indem der Empfänger der Mikrospule ebenfalls auf Empfang geschaltet wird. Dies ist in der fünften Zeile in Fig. 3 gestrichelt angedeutet.

Der zeitliche Verlauf des Gradientenfeldes G_{z} ist außerdem durch die zeitliche Lage der beiden Hochfrequenzimpuls bestimmt: Die Zeitdauer zwischen dem Maximum des zweiten Hochfrequenzimpulses HF2 und der halben Empfangszeit der Hochfrequenzempfangsspule (t₂ - t₁) sollte bei den gezeigten Gradientenverläufen der Zeitdifferenz zwischen den beiden Hochfrequenzimpulsen (t₁ - t₀) entsprechen, um das größtmögliche Spin-Echo-Signal empfangen zu können.

Um auch die dritte Koordinate der Position des Katheters und/oder weitere Line-Scans in zum ersten Line-Scan orthogonalen Richtungen zu erhalten, wird die gezeigte Sequenzfolge weitere ein- oder zweimal wiederholt, wobei die Richtungen der Gradientenfelder zyklisch in geeigneter Weise vertauscht werden. Dieses Verfahren wird fortlaufend während der Bewegung des Katheters im Körper wiederholt, um die Bewegung des Katheters im Körper verfolgen zu können und MR-Bilder zu erstellen, die den Umgebungsbereich des Katheters zeigen.

Wichtig ist bei der Durchführung des beschriebenen Verfahrens, daß die Geschwindigkeit des Katheters nicht zu groß ist, damit der Katheter nicht während der Positionsbestimmung und der Erfassung eines oder mehrerer Line-Scans aus der angeregten Schicht heraus bewegt wird. Außerdem muß mit dem ersten Hochfrequenzimpuls HF1 eine Schicht angeregt werden, in der sich die Mikrospule befindet. Dazu ist beispielsweise vor der Durchführung des erfindungsgemäßen Verfahrens die Position des Katheters nach einem bekannten Verfahren zu bestimmen. Während des Verfahrens kann jeweils die gerade bestimmte Position des Katheters dazu herangezogen werden, die Frequenz für den ersten Hochfrequenzimpuls HF1 auszuwählen, mittels derer die Lage der angeregten Schicht bestimmbar ist. Ebenso kann die Position dazu verwendet werden, die Frequenz des zweiten Hochfrequenzimpulses HF2 auszuwählen, mittels derer die Lage der Schicht bestimmt wird, in der die Kernspins refokussiert werden.

Es könnten auch zunächst einige Katheterpositionen bestimmt werden, um daraus dessen Geschwindigkeit und die Richtung, in die der Katheter bewegt wird, zu bestimmen. Außerdem kann auch aus bisher bestimmten Positionen die Richtung abgeschätzt werden, in die sich der Katheter bewegen wird.

Für die Durchführung des erfindungsgemäßen Verfahrens ist es nicht erforderlich, daß die Hochfrequenzimpulse HF1 und HF2 die beschriebenen Winkel von 90° bzw. 180° aufweisen. Abhängig von der erforderlichen Repetitionszeit der MR-Sequenz können die Hochfrequenzimpulse auch andere Winkel aufweisen.

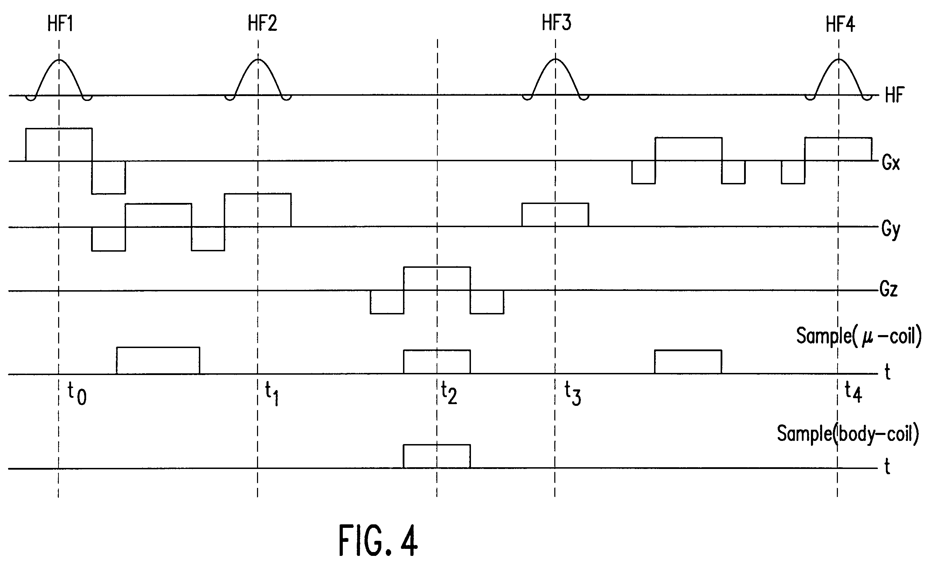

In Fig. 4 ist eine weitere Sequenzfolge zur Durchführung des erfindungsgemäßen Verfahrens dargestellt. Bis zum Zeitpunkt t₂ entspricht diese Sequenz genau der in Fig. 3 beschriebenen Sequenz. Um mit dieser Sequenz auch noch die dritte Koordinate der Katheterposition zu bestimmen, wird zunächst die Polarität des Gradientenfeldes G_{z} wieder in negative Richtung umgekehrt, und zwar so lange, daß am Ende alle Kernspins wieder in Phase sind. Nach Abschaltung des Gradientenfeldes G_{z} wird ein weiterer 180°-Hochfrequenzimpuls HF3 mit dem Maximum zum Zeitpunkt t₃ erzeugt, wobei zeitlich parallel ein Gradientenfeld G_{y} mit positiver Polarität angelegt wird. Dadurch erfolgt wiederum eine Schichtselektion in y-Richtung. Nach Abschaltung des Gradienten G_{y} und des Hochfrequenzimpulses HF3 wirkt schließlich ein Gradientenfeld Gₓ auf den Untersuchungsbereich ein, der den gleichen zeitlichen Verlauf hat wie der zeitlich vorher (zum Zeitpunkt t₂) angelegte Gradient G_{z}.

Während des Zeitraums, in dem dieses Gradientenfeld Gₓ konstant mit positiver Polarität ist, kann schließlich die dritte Koordinate (in x-Richtung) der Katheterposition bestimmt werden, was aus der fünften Zeile ersichtlich ist.

Um Sättigungseffekte zu reduzieren und die Zeit zu verringern, bis mit einer erneuten Sequenz die nächste Position bzw. der nächste Line-Scan bestimmt werden kann, wird nun zum Zeitpunkt t₄ ein weiterer 90°-Hochfrequenzimpuls angelegt, der die Magnetisierungsrichtung der Kernspins wieder in die ursprüngliche Ausgangslage (in z-Richtung) vor Beginn der ganzen Sequenz bringt. Gleichzeitig dazu ist ein Selektionsgradient Gₓ mit positiver Polarität angelegt. Zeitlich davor und vor Anlegen des Hochfrequenzimpulses HF4 wird noch ein Gradientenfeld Gₓ mit negativer Polarität angelegt, der eine Rephasierung der Magnetspins bewirkt.

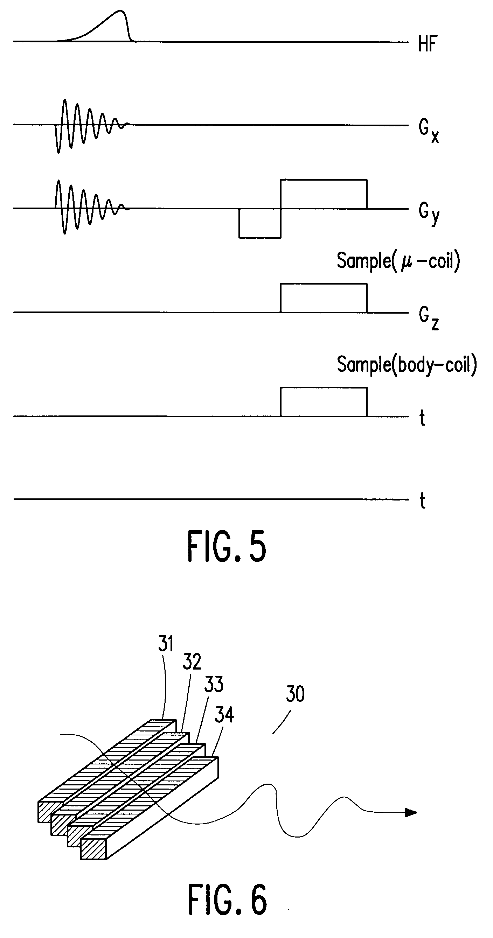

In Fig. 5 ist eine alternative Sequenzfolge für das erfindungsgemäße Verfahren dargestellt. Dabei wird die Magnetisierung in einem linienförmigen Bereich in z-Richtung durch einen unsymmetrischen Hochfrequenzimpuls und zeitlich parallel dazu angelegte oszillierende Gradientenfelder Gₓ und G_{y} angeregt. Diese Art der Anregung eines linienförmigen zylindrischen Bereiches ist aus Journal of Magnetic Resonance 81, p. 43-56 (1989) bekannt und soll deshalb hier nicht näher beschrieben werden. Danach wird wiederum der bereits im Zusammenhang mit Fig. 3 beschriebene Lesegradient G_{z} angelegt, wobei gleichzeitig nach dessen Polaritätsumkehr von der Mikrospule und der Hochfrequenzempfangsspule MR-Signale empfangen werden. Mit dieser Sequenz kann eine Koordinate der Position der Mikrospule sowie ein Line-Scan (hier in z-Richtung) um diese Position erstellt werden. Nach zwei weiteren Wiederholungen dieser Sequenz mit zyklischer Vertauschung der Gradienten erhält man alle drei Komponenten der Position sowie drei zueinander orthogonale Line-Scans.

In Fig. 6 ist mit 30 der Verlauf eines Katheters, beispielsweise in einer Blutbahn bezeichnet. Mit 31 bis 34 sind vier Line-Scans gezeigt, die während der Bewegung des Katheters durch den Körper entlang der Kurve 30 mit dem erfindungsgemäßen Verfahren bestimmt wurden.

Der Zyklus aus Positionsbestimmung des Katheters und Messung eines oder mehrerer Line-Scans um jede gemessene Position des Katheters wird während der Intervention wiederholt, so daß es möglich ist, ein MR-Bild des zurückgelegten Weges des Katheters zu erstellen. Im allgemeinen wird die Oberfläche, die von den Line-Scans auf diese Weise erfaßt wird, aber keine ebene Fläche bilden, da der Katheter im allgemeinen nicht entlang einer in einer Ebene liegenden Kurve bewegt wird und die Lage der Line-Scans von der Position des Katheters abhängt.

Das MR-Verfahren kann in der Weise erfolgen, daß je gemessener Position des Katheters genau drei Line-Scans erfaßt werden, die orthogonal zueinander angeordnet sind. Dies ist besonders vorteilhaft, da der Arzt sich anhand orthogonaler Schichtbilder sehr leicht orientieren kann. Es jedoch auch möglich, Line-Scans zu erstellen, die nicht orthogonal zueinander liegen. Ebenso ist es nicht erforderlich, daß die Line-Scans entlang der Hauptachsen liegen, entlang derer auch die Gradientenfelder ausgerichtet sind.

Das Verfahren kann auch derart erweitert werden, daß nicht nach jeder Positionsbestimmung des Katheters Line-Scans erstellt werden, sondern erst dann, wenn der Katheter einen bestimmten Weg zurückgelegt hat. Dies gewährleistet, daß die Darstellung bei der Aneinanderreihung der Line-Scans entlang einer Richtung möglichst isotrop ist.

## Patentansprüche

1. MR-Verfahren, bei dem die Position eines in einen zu untersuchenden Körper eingeführten Gegenstandes bestimmt wird zur Verfolgung des Gegenstandes während seiner Bewegung im Körper,
dadurch gekennzeichnet, daß mindestens eine Koordinate der Position des Gegenstandes bestimmt wird, daß danach die Kernmagnetisierung in einem linienförmigen Bereich um diese Position bestimmt wird zur Erstellung von MR-Bildern eines Umgebungsbereiches des Gegenstandes und daß dieses Verfahren fortlaufend während der Bewegung des Gegenstandes für verschiedene Positionen des Gegenstandes wiederholt wird.

2. MR-Verfahren nach Anspruch 1,
dadurch gekennzeichnet, daß alle drei Koordinaten der Position des Gegenstandes bestimmt werden und daß danach die Kernmagnetisierung in einem, zwei oder drei zueinander orthogonalen lininenförmigen Bereichen um diese Position bestimmt wird.

3. MR-Verfahren nach Anspruch 1,
dadurch gekennzeichnet, daß nacheinander in drei Verfahrensschritten die drei Koordinaten der Position des Gegenstandes sowie die Kernmagnetisierung in drei orthogonal zueinander angeordneten linienförmigen Bereichen um diese Position bestimmt werden, wobei in einem Verfahrensschritt genau eine Koordinate der Position des Gegenstandes und die Kernmagnetisierung in einem linienförmigen Bereich um diese Position bestimmt werden.

4. MR-Verfahren nach einem der vorhergehenden Ansprüche,
dadurch gekennzeichnet, daß die Bestimmung mindestens einer Koordinate der Position des Gegenstandes und die Bestimmung der Kernmagnetisierung in einem linienförmigen Bereich mittels einer einzigen MR-Sequenz erfolgen.

5. MR-Verfahren nach einem der vorhergehenden Ansprüche,
dadurch gekennzeichnet, daß mindestens ein MR-Übersichtsbild erstellt wird und daß die Position des Gegenstandes und/oder der linienförmige Bereich um diese Position in das MR-Übersichtsbild eingeblendet werden.

6. MR-Verfahren nach einem der vorhergehenden Ansprüche,
dadurch gekennzeichnet, daß die aktuelle Position des Gegenstandes oder der von dem Gegenstand zurückgelegte Weg verwendet wird zur Auswahl der anzuregenden Schicht für die nächstfolgende Positionsbestimmung und für die Bestimmung der Kernmagnetisierung in einem linienförmigen Bereich um die nächstfolgende Position.

7. Anordnung zur Durchführung des Verfahrens nach einem der vorhergehenden Ansprüche mit
- einer Gradientenspulenanordnung (3, 5, 7) zur Erzeugung von magnetischen Gradientenfeldern in einem von einem stationären homogenen Magnetfeld durchsetzten Untersuchungsbereich,
- einer Hochfrequenzspulenanordnung (9, 11) zur Erzeugung eines hochfrequenten Magnetfeldes bzw. zum Empfang von MR-Signalen aus dem Untersuchungsbereich,
- einem in den Untersuchungskörper einzuführenden Gegenstand mit Mitteln (10) zum Empfang von MR-Signalen aus dem Umgebungsbereich,
- Mitteln (17) zur Steuerung des zeitlichen Verlaufs der Ströme in der Gradientenspulenanordnung (3, 5, 7) und/oder der Hochfrequenzspulenanordnung (9, 11) und/oder der Mittel (10), wobei die Steuerung derart erfolgt, daß mindestens eine Koordinate der Position des Gegenstandes bestimmt wird, daß danach die Kernmagnetisierung in einem linienförmigen Bereich um diese Position bestimmt wird zur Erstellung von MR-Bildern eines Umgebungsbereiches des Gegenstandes und daß dieses Verfahren fortlaufend während der Bewegung des Gegenstandes für verschiedene Positionen des Gegenstandes wiederholt wird, und mit
- Mitteln (15) zur Wiedergabe der aus den gemessenen Werten erstellten MR-Bilder.

8. Anordnung nach Anspruch 7,
dadurch gekennzeichnet, daß die Mittel (10) zum Empfang von MR-Signalen aus dem Umgebungsbereich eine Mikrospule oder einen Permanent- oder Elektromagneten aufweisen.
